# EUROPEAN PATENT SPECIFICATION

(11) **EP 2 298 046 B1**
(45) Date of publication and mention of the grant of the patent: **19.03.2014**
(21) Application number: 09750817.0
(22) Date of filing: 22.05.2009
(51) Int. Cl.: H05K 3/38, H05K 3/10

(54) **Providing a plastic substrate with a metallic pattern**
Versehen eines Kunststoffsubstrats mit einem Metallmuster
Application d' un motif métallique sur un substrat plastique

(30) Priority: 23.05.2008 EP 08156833
(43) Date of publication of application: 23.03.2011
(73) Proprietor: Nederlandse Organisatie voor Toegepast -Natuurwetenschappelijk Onderzoek TNO, 2628 VK Delft (NL)
(72) Inventor: MEINDERS, Erwin, Rinaldo, NL-5508 WB Veldhoven (NL); PETER, Maria, NL-5658 GE Eindhoven (NL); FURTHNER, Francois, NL-5644 GJ Eindhoven (NL); TACKEN, Roland Anthony, NL-5663 SH Geldrop (NL)
(74) Representative: Jansen, Cornelis Marinus
(86) International application number: PCT/NL2009/050280
(87) International publication number: WO 2009/142497

(56) References cited:
- EP-A- 1 676 937
- EP-A- 1 777 997
- WO-A-2005/109095
- US-A- 3 042 591
- US-A1- 2002 119 251
- US-A1- 2004 124 533
- US-A1- 2004 187 310
- US-A1- 2005 186 774
- US-A1- 2006 008 627
- US-A1- 2006 159 854
- US-A1- 2006 213 957
- L. JAY GUO: "Nanoimprint Lithography: Methods and Material Requirements" ADVANCED MATERIALS, vol. 19, February 2007 (2007-02), pages 495-513, XP002499045

## Description

The invention is directed to a method of providing a plastic substrate with a metallic pattern.

Substrates having electrically conductive micro-patterns thereon are used in a wide variety of electronic applications. Glass substrates used for LCDs, touch screens for visual displays, and consumer electronic displays all require electrically conductive lines to be formed thereon to provide the desired functionality. Also flexible plastic substrates provided with a metallic pattern have high potential as electronic circuits and electrodes. In particular, plastic substrates having conductive micro-patterns thereon can be used in electronic applications, such as flexible displays, rollable displays, smart blisters, radiofrequency identification (RFID) tags, smart labels, electrode arrays for bio-sensing and other sensor applications with distributed transistors, pressure sensors, *etc*.

Typically, the micro-patterns formed on a glass or silicon substrate are prepared by a process which comprises a metal deposition step followed by a photolithography step. When a plastic substrate is used, it is difficult to form a metallic micro-pattern directly on the surface of the plastic due to its dimensional instability and deformability caused by a high thermal expansion coefficient and by moisture loss or uptake, and its sensitivity to organic solvents and weak interaction between plastic surface and metal pattern, and accordingly, a screen-printing or electroplating method has conventionally been used, see for instance US-A-6 030 515. However, such a screen-printing method has limited resolution and defect level sensitivity. Patterning plastic substrates by electroplating requires a pre-deposited, eventually pre-patterned seed layer or post-patterning *e.g.* by photolithography.

Another method is described in US-A-2003/0 024 632, which uses a reactive metal micro-pattern on the surface of an inorganic substrate as a stamper to provide a plastic substrate with a metal micro-pattern by transfer printing. Disadvantages of this method are that many expensive and time consuming manufacturing steps are involved: metal deposition on the inorganic substrate, the definition of micro-patterns on the inorganic substrate by photolithography, surface treatment/activation of the plastic substrate, pattern transfer by contact printing. These steps give rise to many defects. In addition, this method is incompatible with roll-to-roll manufacturing.

US-A-5 830 533 describes a method in which a seed layer is deposited on a dielectric substrate. The seed layer is overlaid with a patterned photoresist mask and then exposed portions of the seed layer are etched away. Then the photoresist mask is removed thereby exposing the unetched portions of the seed layer. Finally, the unetched portions of the seed layer are used to deposit metal on the dielectric substrate *e.g.* by electroless deposition. Disadvantage of this method is that the use of a mask is expensive.

US-A-2004/0 187 310 describes a method according to which the surface of an imprinting stamp is coated with a seed layer. The seed layer is then transferred to a substrate by micro-contact imprinting, after which the seed layer can be used for metal deposition. The seed layer is not provided on the substrate in a selective way and therefore this method requires removal of seed layer from regions of the substrate where seeding is not needed, *e.g.* by grinding. In addition, this is a soft-imprint step (micro-contact printing). Also in this case, the resolution is limited and it is difficult to assure total/defectless seed transfer.

US-A-2002/0 119 251 describes a method for forming a metallic feature on a substrate, comprising providing a stamp having a raised region, depositing catalytic particles on selected area of the stamp and applying the stamp to the substrate.

US-A-2005/0 186 774 describes a method wherein an imprinting stamp is utilized to imprint a pattern onto or into a surface of a material. The material may comprise a conductive layer and an overlying dielectric layer. The stamp can be a micro-contact printing stamp.

Accordingly, there remains an exited need for developing an improved and cost-effective method for forming a high resolution metal micro-or even nano-pattern on a plastic substrate. Also, the compatibility with roll-to-roll manufacturing for the desired resolution is lacking in the prior art.

Object of the invention is to provide a method for providing a plastic substrate with a metallic pattern, which method at least partly overcomes the disadvantages faced in the prior art.

Further object of the invention is to provide a method for providing a plastic substrate with a metallic pattern, which method is relatively easy and results in a plastic substrate having an accurate conductive metal pattern thereon. In addition, it would be highly advantageous if the method is cost-effective and compatible with roll-to-roll processing.

The inventors found that one or more of these objects can be met by providing a method in which a pattern is first replicated in the plastic substrate and subsequently seed material is applied on the pattern in a selective pattern. The patterned seed material is then subsequently used to deposit metal in a controlled manner.

Accordingly, the invention is directed to a method as defined in claim 1.

The inventors found that this method has high potential, because it yields plastic substrates with highly accurate metallic patterns. In addition, the method of the invention allows cost-effective manufacturing of high accuracy, well defined metal patterns at different length scales, and is compatible with roll-to-roll processing. Furthermore, the method of the invention is highly advantageous from a process technological point of view, because of the few process steps required. There is no need to remove seed material from underisable areas, because the seed material is selectively applied. Hence, the method of the invention requires less process steps than prior art methods.

The term "pattern" as used in this application is meant to refer to a geometric arrangement of features. The features can *e.g.* be lines, squares, circles, dots, any other shapes, or combinations thereof.

The term "recess" as used in this application is meant to refer to any shape extending inward from the plane of the surface, *e.g.* a trench. It is not intended to limit the dimension or shape of the recess.

The term "protrusion" as used in this application is meant to refer to any shape extending outward from the plane of the surface. It is not intended to limit the dimension or shape of the protrusion.

In case a substrate surface has recesses, then the parts of said substrate surface not forming said recesses inherently form protrusions. Similarly, in case a substrate surface has protrusions, then the parts of said substrate surface not forming said protrusions inherently form recesses.

The plastic substrate can be any polymer substrate, such as polyesters like polyethylenenaphthalate (PEN) and polyethyleneterephthalate (PET), polyimide (PI), polyetherimide (PEI), polymethylmethacrylate (PMMA), polycarbonate (PC), polyamide (PA), polyethersulphones (PES), polydimethylsiloxane, polyepoxides, polyolefins, polyarylates, or the like, or fibre reinforced polymers. The substrate can be thin such that it becomes flexible or even stretchable. The substrate can be self-supporting or may be supported by a rigid carrier such as glass, silicon, metal, a thick polymer, *etc*. The term substrate is meant to include layers applied on the plastic, such as an imprint layer coated on the plastic material. Thus, the plastic substrate can comprise an imprint layer. Such an imprint layer may for instance be thermally curable (including thermoplastic polymers which become fluid above their melting temperature and solidify below their glass transition temperature, such as polyimide (PI), polymethyl methacrylate (PMMA), polystyrene (PS), and the like) and/or ultraviolet (UV) curable (including epoxies (such as SU8 described in US-A-4 882 245), acrylates, and the like). If the substrate comprises an imprint layer the recesses and protrusions are preferably provided into said imprint layer.

According to one step of the method of the invention a pattern of recesses and protrusions is replicated on a plastic substrate by pressing a stamp having recesses and protrusions against the substrate, thereby providing said plastic substrate with recesses and protrusions. The stamp can be a regular stamp or a template, but also a mould (replica from the stamp/template). The stamp can be made out either of a rigid material or a soft polymeric material. Suitable methods for replicating a pattern on a substrate for instance include hot embossing, injection moulding, UV curing, phase-separation or the like. In case the substrate comprises an imprint layer, the stamp is preferably pressed against the surface of the substrate on which the imprint layer is applied.

Thus, in an embodiment the stamp is pressed against a surface of the substrate at a temperature which is higher than the glass transition temperature of the plastic material of said substrate, thereby providing the substrate with recesses and protrusions. In case the substrate comprises an imprint layer, the stamp can be pressed against the substrate at a temperature which is higher than the glass transition temperature of said imprint layer.

It is also possible that the stamp is pressed against the surface of the substrate at a temperature which is higher than the melting temperature of the plastic material of said substrate, thereby providing the substrate with recesses and protrusions. In case the substrate comprises an imprint layer, the stamp can be pressed against the substrate at a temperature which is higher than the melting temperature of said imprint layer.

In case the substrate comprises a UV curable imprint layer, a transparent stamp (such as a stamp made of quartz, polydimethylsiloxane (PDMS), or the like) can be pressed against a surface of the substrate followed by curing with UV irradiation through said stamp. In further embodiment, the substrate excluding said imprint layer is transparent and the imprint layer can be cured with UV irradiation through the substrate. It is also possible to simultaneously press the stamp onto a surface of the substrate and irradiate the imprint layer with UV irradiation.

In case the substrate comprises a thermally curable liquid-like imprint layer, pressing the stamp onto a surface of the substrate may be followed by a heating step in which the imprint layer is cured. This heating step may also be carried out simultaneously with pressing the stamp onto a surface of the substrate.

In a special embodiment, the substrate comprises an imprint layer that comprises at least two polymeric components and while pressing the stamp or mould against the substrate, a vertical phase separation of the at least two polymers is induced. The phase-separation results in solidification of the two phases such that a structured surface remains.

In accordance with the invention, the recesses and/or protrusions of the stamp comprise nanostructures. The recesses and protrusions of the stamp have a different surface roughness and are able to provide the substrate with recesses and protrusions having different wetting properties. The substrate can thus be provided with recesses and/or protrusions that are hydrophobic or hydrophilic. Preferably, the recesses are rendered hydrophobic and the protrusions are rendered hydrophilic or *vice versa*. In this case it is highly advantageous that the stamp surface which is to be pressed against the plastic substrate (optionally comprising an imprint layer) is micro-machined in such a way that the replication step already results in protrusions and recesses having different wetting properties due to roughness differences.

After the stamp has been pressed against the plastic substrate the stamp is removed from the substrate, thus leaving a patterned plastic substrate.

Thereafter, a layer of seed material capable of initiating an electroless or electrochemical metal deposition process is provided onto the plastic substrate as a selective pattern at least in the recesses of the plastic substrate. The purpose of the seed material is to deposit a thin, conductive layer or film to act as an initiator for an electroless or electrochemical metal deposition process. The seed material can be a curable material, such as thermally curable or UV curable. In an embodiment the seed material comprises nanoparticles (comprising elements selected from the group consisting of Ag, Au, Cu, Fe, Ni, Pd, Pt, Sn, Co, light or heat sensitive organic molecules, inks, organometallic compounds, metal salts, and metal sulphides. Suitable metals for the seed layer include Cr, Al, Au, Cu, Ni, Ag, Pd, Ru, Pt, W, and Ti. Suitable non-metals include conducting polymers, *e.g.* polyaniline or polypyrrole, conducting powders, and enzymes.

The seed material is applied as a selective pattern. The seed material is preferably applied directly onto the plastic substrate, which is provided with recesses and protrusions. In case the plastic substrate comprises an imprint layer, the seed material is preferably applied directly onto the imprint layer, which is provided with recesses and protrusions. Optionally, an adhesion promoter or promoting treatment can be applied between the substrate and the layer of seed material to improve the adhesion of the seed material on the substrate. Such adhesion promoters are well-known in the art and include *e.g.* plasma treatment, UV/ozone treatment, self-assembled monolayers (alkyl or aryl chlorosilanes, alkoxysilanes, Langmuir-Blodgett films, and the like, having one or more reactive functional groups such as -OH, -NH₂, -COOH, capable of promoting the adhesion of a third material), polymer coatings, any organic or inorganic coating that has a higher surface energy than the substrate thereby promoting the adhesion of the seed (examples thereof include silane compounds, such as aminopropyltriethoxysilane (APTES) or alkyl or aryl chlorosilanes, alkoxysilanes, Langmuir-Blodgett films, and the like, having one or more reactive functional groups such as -OH, -NH₂, -COOH, capable of promoting the adhesion of a third material.

Application of the seed material in a selective pattern can be followed by an isotropic etch step. This means that the etching process propagates in the same way and/or rate in each direction. The etching step can be a wet or dry etching step. During the etching step excess seed is removed from the protrusions of the substrate, while seed material is left in the recesses of the substrate.

Another way of applying the seed material onto the substrate is by printing, such as inkjet printing, gravure printing, or offset printing. The seed material may comprise a UV curable component which can be cured during or after printing in the desired areas, *e.g.* by using ultraviolet radiation through a mask. Another option is to use optical interference curing, according to which two interfering light beams cure the ink in the areas where the intensity of the light is sufficiently high due to positive interference. It is also possible to cure the ink locally using a focussed laser beam, preferably a UV laser beam. Another possibility is curing the ink using a two-photon polymerisation process. Uncured seed material can thereafter be washed off.

Other ways of applying the seed material are conventional metal film deposition techniques (evaporation, sputtering, vapour deposition (chemical or physical), plasma enhanced deposition and the like, in combination with a mask.

The recesses and the protrusions in or on the surface of the plastic substrate have different wetting properties. The recesses or the protrusions may for instance selectively be rendered hydrophilic, for example by introducing an appropriate surface roughness using a micro- and/or nanostructured stamp (also known as micro- or nano-machining). The seed material can then be deposited by conventional techniques over the entire substrate surface. Such techniques include spin-coating, squeegee-based filling, printing, dip coating, vapour deposition, evaporation, sputtering, and plasma enhanced deposition. Although being applied over the entire substrate surface in this case, the seed material only adheres in a selective pattern, which is governed by the different wetting properties of the recesses and the protrusions of the substrate surface. Hence, the application of the seed material nevertheless yields a selective pattern of seed material. Both, recesses or protrusions can be rendered hydrophobic, depending where seed material is to be deposited. The difference in water contact angle between the recesses and the protrusions is preferably at least 30°, preferably at least 40°, in order to prevent non-specific deposition in the areas where seed material is undesired. The difference in water contact angle can suitably be 30-60°. Water contact angles can be measured using a digital camera. In order to determine the difference in water contact angles between the recesses and the protrusions a larger surface can be made, which has the properties of the recesses (material, structures the same *etc*.). Also, a larger surface with the properties of the protrusions can be made. Then, the water contact angle of these larger surfaces is measured, so that a difference in water contact angle between the recesses and the protrusions can be determined.

In one embodiment both the recesses and the protrusions are hydrophobic, in another embodiment both the recesses and the protrusions are hydrophilic, and in yet another embodiment one of them is hydrophobic while the other is hydrophilic.

It is, however, also possible to provide the recesses and/or protrusions with different affinities for oils. In this case, the difference in contact angle for non-polar solvents between the recesses and the protrusions is preferably at least 30°, preferably at least 40. The difference in contact angle for non-polar solvents can suitably be 30-60°. The recesses or the protrusions may for instance selectively be rendered oleophilic or oleophobic. Oleophobic surfaces repel non-polar solvents such as toluene, benzene, hexane *etc*. Usually, hydrophilic surfaces are also oleophobic, but there are exceptions, such as fluorocarbons which repel both water and non-polar solvents rendering them hydrophobic and oleophobic at the same time.

In an embodiment, a difference in wetting properties of the recesses is introduced or enhanced by chemical or physical surface modification or functionalisation. Chemical surface modification includes the introduction of hydrophilic (*e.g.* -OH, -NH₂, -COOH, *etc*.) and/or hydrophobic groups on the substrate surface (-CH₃, -CF₃, *etc.*). In an advantageous embodiment, the above-mentioned micro-machining is combined with a chemical surface modification. The recesses and/or protrusions can for instance be chemically modified by (a) using a mask, (b) modifying the surface using a selective printing technique, or (c) modifying the whole surface prior to replication after which the mechanical contact during replication partly destroys the modification at the contacted areas. In case chemical functionalisation is used complementary to surface roughening, then it is not required to apply the functionalisation in a patterned manner, but it can enhance or minimise the already existing wetting property of the surface.

In a further step the substrate is subjected to electroless or electrochemical metal deposition process in order to metallise the exposed pattern of seed material. Suitable metal deposition processes for instance include electroless plating (such as electroless copper, nickel, nickel-phosphorous or nickel-boron, silver, tin or gold plating), and electrochemical deposition or plating of metals.

Typically, the electroless or electrochemical metallisation involves the use of organic or inorganic electrolytes (salts dissolved in organic solvents or in water) and/or ionic liquids. Ionic liquids comprise molten salts, in particular salts that are liquid below 100 °C. The cations of the ionic liquid can for instance be selected from the group consisting of monosubstitued imidazolium, disubstituted imidazolium, trisubstituted imidazolium, pyridinium, pyrrolidinium, phosphonium, ammonium, guanidinium, tri-substituteted sulphonium and isouronium, or derivatives thereof. The anions of the ionic liquid can for instance be selected from the group consisting of chloride, bromide, iodide, nitrate, nitrite, fluoride, phosphate, imide, amide, borate, tosylate, tetrafluoroborate, hexafluoroborate, hexafluorophosphate, trifluoromethanesulphonate, methylsulphate, bis(pentafluoroethyl)phosphinate, thiocynate, octylsulphate, hexylsulphate, butylsulphate, ethylsulphate, dicyanamide, hexafluoroantimonate, bis-(pentafluoroethyl)phosphinate, bis-(trifluoromethyl)imide, trifluoroacetate, bis-trifluorosulphonimide, and dicyanamide.

Optionally, the method of the invention may be followed by a step in which the layer of seed material is removed from non-metallised areas of the plastic substrate.

The method of the invention can advantageously be performed in a roll-to-roll fabrication method, because thin plastic substrates can be processed from a roll while unwinding, processing and rewinding. Conventional methods in which rigid substrates are used, are not suitable for roll-to-roll fabrication.

In order to preserve the aspect ratio of the structures (defined as the ratio between the height and lateral dimensions) through the whole process, a grid of finer structures can be used at the bottom of the recesses. Large area parts of the substrate are covered with a grid of recesses such that the aspect ratio is not sacrificed. In this case, the seed layer is patterned according to the method of the invention. The finer grid prevents levelling of the seed layer, and thus the absence of patterning.

Also disclosed is a plastic substrate with a metallic pattern obtainable by the method of the invention. Such substrates can suitably have submicron structures and can advantageously be used in embedded conductors.

Also disclosed is an electronic device comprising the plastic substrate with a metallic pattern of the invention. Suitable examples of such a device include an electrode array, flexible displays, rollable displays, smart blisters, radiofrequency identification (RFID) tags, smart labels, electrode arrays for bio-sensing and other sensor applications with distributed transistors, pressure sensors, wearable devices, *etc.*

The invention will now be illustrated by means of the following specific embodiments which are not meant to limit the invention in any way, and which may optionally be combined.

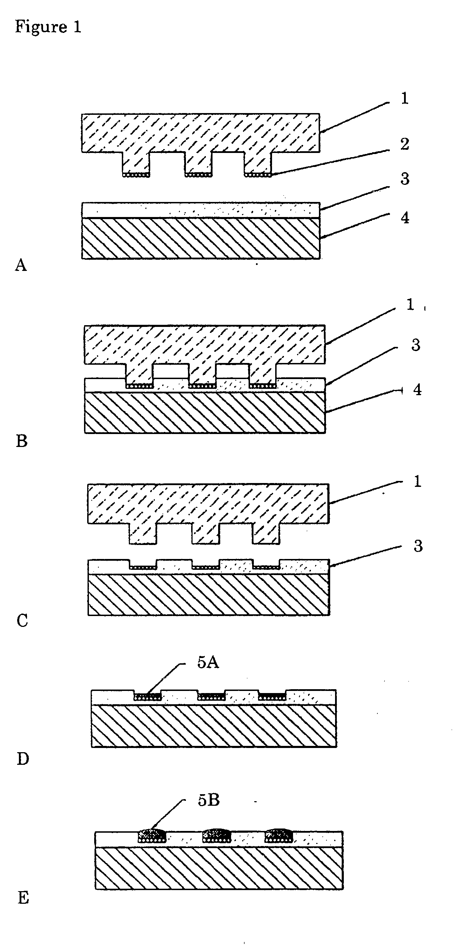

In a first embodiment not according to the invention a pattern is replicated in a substrate coated with an imprint layer. This embodiment is illustrated by Figure 1.

A patterned stamp (1) (having protrusions and recesses) is inked with seed material (2) capable of initiating an electroless or electrochemical metal deposition process. The stamp can be inked such that seed material selectively adheres onto the protrusions (*e.g.* by dipping the stamp before imprinting in a molten metal such as Sn or Pb, or metal salt). The stamp is then pressed against a plastic substrate (4) comprising an imprint layer (3). Pressing the stamp (1) against the imprint layer (3) can be accompanied by heating. The replication results in a substrate comprising recesses and protrusions in said imprint layer, wherein selectively the recesses are provided with seed material.

After removal of the stamp the seed material adheres to the surface of the recesses of the substrate. The plastic substrate (1) is then subjected to electroless or electrochemical metal deposition. Depending on the deposition time thinner highly conductive structures (5A) or thicker highly conductive structures (5B) will form. These structures can serve as electrodes or other parts of an electric circuit.

In a second embodiment, micro- and/or nanostructures are utilised to enable selective wetting of surfaces depending on pattern structures and sizes.

A stamp is provided with micro- and/or nanostructured areas, for instance the protrusions of the stamps are nanostructured via a laser ablation process. This stamp is used for replicating in a plastic substrate, optionally comprising an imprint layer. This replication step provides the plastic substrate with the micro- and/or nanostructures. Typically, the micro- and/or nanostructures are such that they influence the wetting properties such that the resulting recesses and/or protrusions of the plastic substrate have different wetting properties. This difference in wetting properties is then used to pattern a layer of seed materiaL In a final stage, the deposited seed material is used to initiate an electroless or electrochemical metal deposition process.

The variant of this second embodiment without nanostructures is not according to the invention.

## Claims

1. Method of providing a plastic substrate with a metallic pattern comprising
i) replicating a pattern of recesses and protrusions on a plastic substrate (4) by pressing a stamp (1) having recesses and protrusions against the substrate (4), thereby providing said plastic substrate (4) with recesses and protrusions;
ii) removing said stamp (1) from said substrate (4);
iii) applying a layer of seed material (2) capable of initiating an electroless or electrochemical metal deposition process onto said plastic substrate (4) in a selective pattern at least in the recesses of said plastic substrate (4) to yield a substrate (4) wherein said seed material (2) remains selectively in the recesses,of said substrate (4) ; and thereafter
iv) using said seed material (2) to initiate a metal deposition process, **characterised in that** the recesses and/or protrusions of said stamp (1) comprise nanostructures and **in that** the recesses and protrusions of said stamp (1) have different surface roughness, thereby providing the recesses and protrusions of said substrate (4) with different wetting properties.

2. Method according to claim 1, wherein said plastic substrate (4) comprises a thermally and/or UV curable imprint layer (3), and wherein said recesses and protrusions are provided into said imprint layer (3), preferably said layer of seed material (2) is provided directly onto said imprint layer (3).

3. Method according to claim 1, wherein said stamp (1) is pressed against the substrate (4) at a temperature higher than the glass transition temperature and/or higher than the melting temperature of said plastic substrate (4).

4. Method according to claim 2, wherein said stamp (1) is pressed against the substrate (4) at a temperature higher than the glass transition temperature and/or higher than the melting temperature of said imprint layer (3).

5. Method according to claim any one of claims 2-4, wherein said imprint layer (3) is UV curable and said stamp (1) and/or said substrate (4) is transparent.

6. Method according to claim any one of claims 2-5, wherein said replication is followed by a curing step to cure said thermally and/or LTV curable imprint layer (3) comprising applying heat and/or UV irradiation to said imprint layer (3).

7. Method according to any one of the preceding claims, wherein said pressing induces vertical phase separation of at least two polymers comprised in said substrate (4).

8. Method according to any one of the preceding claims, wherein said recesses and protrusions have a difference in water contact angle of at least 30°, preferably at least 40°.

9. Method according to any one of the preceding claims, wherein said layer of seed material (2) is curable and at least part of said seed material (2) is cured after being provided onto said substrate (4), preferably uncured seed material (2) is removed after curing said layer of seed material (2) .

10. Method according to any one of the preceding claims, wherein said layer of seed material (2) is provided by a method selected from
- printing, or
- vapour deposition, sputtering, or plasma enhanced deposition, in combination with a mask.

11. Method according to any one of the preceding claims, further comprising a step wherein said layer of seed material (2) is removed from non-metallised areas of said substrate (4).

12. Method according to any one of the preceding claims, wherein said seed material (2) comprises one or more selected from nanoparticles, light or heat sensitive organic molecules, inks, organometallic compounds, metal salts, conductive polymers, conducting powders, and enzymes.

13. Method according to any one of the preceding claims performed in a roll-to-roll fabrication method.

## Patentansprüche

1. Verfahren zum Versehen eines Kunststoffsubstrats mit einem Metallmuster, umfassend
i) Nachbilden eines Musters von Vertiefungen und Vorsprüngen auf einem Kunststoffsubstrat (4), indem man einen Stempel (1) mit Vertiefungen und Vorsprüngen gegen das Substrat (4) drückt und wobei das Kunststoffsubstrat (4) mit Vertiefungen und Vorsprüngen versehen wirdt;
ii) Entfernen des Stempels (1) von dem Substrat (4);
iii) Anbringen einer Schicht von Keimmaterial (2), das in der Lage ist, einen elektrolosen oder elektrochemischen Metallablagerungsprozess auf dem Kunststoffsubstrat (4) auszulösen, in einem selektiven Muster zu mindest in den Vertiefungen des Kunststoffsubstrats (4), um ein Substrat (4) zu ergeben, wobei das Keimmaterial (2) selektiv in den Vertiefungen des Substrats (4) bleibt; und danach
iv) Verwenden des Keimmaterials (2) zum Auslösen eines Metallablagerungsprozesses, **dadurch gekennzeichnet, dass** die Vertiefungen und/oder Vorsprünge des Stempels (1) Nanostrukturen umfassen und dass die Vertiefungen und Vorsprünge des Stempels (1) verschiedene Oberflächenrauigkeiten aufweisen, wobei die Vertiefungen und Vorsprünge des Substrats (4) mit unterschiedlichen Benetzungseigenschaften versehen werden.

2. Verfahren nach Anspruch 1, wobei das Kunststoffsubstrat (4) eine thermisch und/oder UV-härtbare Prägeschicht (3) umfasst und wobei die Vertiefungen und Vorsprünge in der Prägeschicht (3) bereitgestellt sind, vorzugsweise ist die Schicht des Keimmaterials (2) direkt auf der Prägeschicht (3) bereitgestellt.

3. Verfahren nach Anspruch 1, wobei der Stempel (1) bei einer Temperatur, die höher als die Glasübergangstemperatur und/oder höher als die Schmelztemperatur des Kunststoffsubstrats (4) ist, gegen das Kunststoffsubstrat (4) gedrückt wird.

4. Verfahren nach Anspruch 2, wobei der Stempel (1) bei einer Temperatur, die höher als die Glasübergangstemperatur und/oder höher als die Schmelztemperatur der Prägeschicht (3) ist, gegen das Kunststoffsubstrat (4) gedrückt wird.

5. Verfahren nach einem der Ansprüche 2 - 4, wobei die Prägeschicht (3) UV-härtbar ist und der Stempel (1) und/oder das Substrat (4) transparent ist/sind.

6. Verfahren nach einem der Ansprüche 2 - 5, wobei auf die Nachbildung ein Härtungsschritt zum Härten der thermisch und/oder UVhärtbaren Prägeschicht (3) folgt, umfassend das Anwenden von Wärme und/oder UV-Strahlung auf die Prägeschicht (3).

7. Verfahren nach einem der vorhergehenden Ansprüche, wobei das Drücken die vertikale Phasentrennung von mindestens zwei in dem Substrat (4) enthaltenen Polymeren auslöst.

8. Verfahren nach einem der vorhergehenden Ansprüche, wobei die Vertiefungen und Vorsprünge eine Differenz des Wasserkontaktwinkels von mindestens 30°, bevorzugt von mindestens 40°, aufweisen.

9. Verfahren nach einem der vorhergehenden Ansprüche, wobei die Schicht von Keimmaterial (2) härtbar ist und mindestens ein Teil des Keimmaterials (2) gehärtet wird, nachdem es auf dem Substrat (4) bereitgestellt wurde, vorzugsweise wird ungehärtetes Keimmaterial (2) nach dem Härten der Schicht von Keimmaterial (2) entfernt.

10. Verfahren nach einem der vorhergehenden Ansprüche, wobei die Schicht von Keimmaterial (2) durch ein Verfahren bereitgestellt wird, ausgewählt aus
- Drucken oder
- Dampfablagerung, Bedampfung oder durch plasmaaktivierte Ablagerung, in Kombination mit einer Maske.

11. Verfahren nach einem der vorhergehenden Ansprüche, ferner umfassend einen Schritt, wobei die Schicht von Keimmaterial (2) von nicht metallisierten Bereichen des Substrats (4) entfernt wird.

12. Verfahren nach einem der vorhergehenden Ansprüche, wobei das Keimmaterial (2) eines oder mehrere ausgewählt aus Nanopartikeln, licht-oder wärmeempfindlichen organischen Molekülen, Tinten, organometallischen Zusammensetzungen, Metallsalzen, leitenden Polymeren, leitenden Pulvern und Enzymen, umfasst.

13. Verfahren nach einem der vorhergehenden Ansprüche, durchgeführt in einem Rolle-zu-Rolle-Verfahren.

## Revendications

1. Procédé de fourniture d'un substrat en matière plastique ayant un motif métallique consistant à :
i) répliquer un motif de creux et de saillies sur un substrat en matière plastique (4) en appuyant un poinçon (1) comportant des creux et des saillies contre le substrat (4), en munissant ainsi le substrat en matière plastique (4) de creux et de saillies ;
ii) enlever le poinçon (1) du substrat(4) ;
iii) appliquer une couche de matériau d'ensemencement (2) capable de déclencher un procédé de dépôt auto catalytique ou électrochimique de métal sur le substrat en matière plastique (4) selon un motif sélectif au moins dans les creux du substrat en matière plastique (4) pour donner un substrat (4), dans lequel le matériau d'ensemencement (2) reste sélectivement dans les creux du substrat (4) ; et ensuite
iv) utiliser le matériau d'ensemencement (2) pour déclencher un processus de dépôt de métal, **caractérisé en ce que**
les creux et/ou les saillies du poinçon (1) comprennent des nanostructures et **en ce que** les creux et/ou les saillies du poinçon (1) ont une rugosité de surface différente, munissant ainsi les creux du substrat (4) de propriétés de mouillage différentes.

2. Procédé selon la revendication 1, dans lequel le substrat (4) comprend une couche d'impression (3) durcissable thermiquement et/ou par UV et dans lequel les creux et les saillies sont agencés dans la couche d'impression (3), de préférence la couche de matériau d'ensemencement (2) étant agencée directement sur la couche d'impression (3).

3. Procédé selon la revendication 1, dans lequel le poinçon (1) est appuyé contre le substrat (4) à une température supérieure à la température de transition vitreuse et/ou supérieure à la température de fusion du substrat en matière plastique (4).

4. Procédé selon la revendication 2, dans lequel le poinçon (1) est appuyé contre le substrat (4) à une température supérieure à la température de transition vitreuse et/ou supérieure à la température de fusion de la couche d'impression (3).

5. Procédé selon l'une quelconque des revendications 2 à 4, dans lequel la couche d'impression (3) est durcissable aux UV et le poinçon (1) et/ou le substrat (4) est transparent.

6. Procédé selon l'une quelconque des revendications 2 à 5, dans lequel la réplication est suivie d'une étape de durcissement pour durcir la couche d'impression (3) durcissable thermiquement et/ou par UV comprenant l'application de chaleur et/ou d'un rayonnement UV sur la couche d'impression (3).

7. Procédé selon l'une quelconque des revendications précédentes, dans lequel appuyer induit une séparation de phase verticale d'au moins deux polymères compris dans le substrat (4).

8. Procédé selon l'une quelconque des revendications précédentes" dans lequel les creux et les saillies ont une différence d'angle de contact avec de l'eau d'au moins 30°, de préférence d'au moins 40°.

9. Procédé selon l'une quelconque des revendications précédentes, dans lequel la couche de matériau d'ensemencement (2) est durcissable et au moins une partie du matériau d'ensemencement (2) est durcie après avoir été agencée sur le substrat (4), de préférence le matériau d'ensemencement (2) non durci étant retiré après durcissement de la couche de matériau d'ensemencement (2).

10. Procédé selon l'une quelconque des revendications précédentes, dans lequel la couche de matériau d'ensemencement (2) est agencée par un procédé choisi parmi
• une impression, ou
• un dépôt en phase vapeur, une pulvérisation ou un dépôt renforcé au plasma, en combinaison avec un masque.

11. Procédé selon l'une quelconque des revendications précédentes, comprenant en outre une étape dans laquelle la couche de matériau d'ensemencement (2) est retirée de zones non métallisées du substrat (4).

12. Procédé selon l'une quelconque des revendications précédentes, dans lequel le matériau d'ensemencement (2) comprend un ou plusieurs éléments choisis parmi des nanoparticules, des molécules organiques sensibles à la lumière ou la chaleur, des encres, des composés organométalliques, des sels métalliques, des polymères conducteurs, des poudres conductrices, et des enzymes.

13. Procédé selon l'une quelconque des revendications précédentes, effectué dans un procédé de fabrication de rouleau à rouleau.
